# EUROPEAN PATENT APPLICATION

(11) **EP 3 162 783 A1**
(43) Date of publication of application: **03.05.2017**
(21) Application number: 16194729.6
(22) Date of filing: 20.10.2016
(51) Int. Cl.: C04B 41/85, F01D 5/28

(54) **IMPROVED COATING INTERFACE**

(30) Priority: 30.10.2015 US 201562248635 P; 22.09.2016 US 201615273095
(71) Applicant: Rolls-Royce Corporation, Indianapolis, Indiana 46225 (US)
(72) Inventor: Nelson, Scott, Carmel, IN 46032 (US); Sinatra, Raymond, Indianapolis, IN 46278 (US); Landwehr, Sean, Avon, IN 46123 (US); Dunkin, Michael, Carmel, IN 46033 (US); Moretti, Ashley, Fishers, IN 46037 (US)
(74) Representative: Rolls-Royce plc

(57) **Abstract**

In some examples, the disclosure describes an article and a method of making the same that includes a substrate including a ceramic or a ceramic matrix composite including silicon carbide, where the substrate defines an outer substrate surface and a plurality of grooves formed in the outer substrate surface, where each respective groove of the plurality of grooves exhibits an anchor tooth that spans an edge of the respective groove, and where the plurality of grooves define an average groove width less than about 20 micrometers, and a coating formed on the outer surface of the substrate, where the coating at least partially fills the plurality of grooves of the substrate.

## Description

### TECHNICAL FIELD

The present disclosure relates to coating interfaces, and more particularly, but not exclusively, to coating interfaces on composite substrates.

### BACKGROUND

Ceramic matrix composite (CMC) materials may be useful in a variety of contexts where mechanical and thermal properties are important. For example, components of high temperature mechanical systems, such as gas turbine engines, may be made from CMCs. CMCs may be resistant to high temperatures, but some CMCs may react with some elements and compounds present in the operating environment of high temperature mechanical systems, such as water vapor. These reactions may damage the CMC and reduce mechanical properties of the CMC, which may reduce the useful lifetime of the component. Thus, in some examples, a CMC component may be coated with various coatings, which may reduce exposure of the CMC component to elements and compounds present in the operating environment of high temperature mechanical systems.

### SUMMARY

In some examples, the disclosure describes techniques for improving the adhesion between a substrate and an applied coating layer by forming a plurality of microscopic grooves on the outer surface of the substrate where each respective groove includes an anchor tooth that curves outward from the outer surface of the substrate along an edge of the respective groove to at least partially enclose the groove. In some examples each respective anchor tooth may resemble an ocean wave pattern (e.g., a spilling wave or plunging wave) and may provide an interlocking pattern with the applied coating layer to at least partially mechanically adhere the coating layer to the substrate.

In some examples, the disclosure describes an article including a substrate including a ceramic or a ceramic matrix composite including silicon carbide, where the substrate defines an outer substrate surface and a plurality of grooves formed in the outer substrate surface, where each respective groove of the plurality of grooves exhibits an anchor tooth that spans an edge of the respective groove, and where the plurality of grooves define an average groove width less than about 20 micrometers. The article also includes a coating formed on the outer surface of the substrate, where the coating at least partially fills the plurality of grooves of the substrate.

The plurality of grooves may define an average groove depth of about 10 to about 50 micrometers.

Adjacent grooves of the plurality of grooves may be separated by a distance of about 20 to about 60 micrometers.

The anchor tooth of each respective groove of the plurality of grooves may at least partially secure the coating to the substrate.

Each groove of the plurality of grooves may define at least one of a wavy, a zig-zag, an elliptical, or a circular pattern progressing laterally on the outer substrate surface.

The anchor tooth of each respective groove of the plurality of grooves may curve outward from the outer substrate surface to at least partially enclose the respective groove of the plurality of grooves.

The anchor tooth may define at least one of a plunging wave or a spilling wave along the edge of the respective groove.

The coating may comprise at least one of an environmental barrier coating or a thermal barrier coating.

The coating may comprise a bond coat positioned between the substrate and the at least one of the environmental barrier coating or the thermal barrier coating.

In some examples, the disclosure describes a method for forming an article, the method includes forming a plurality of grooves on an outer substrate surface of a substrate, where the substrate includes a ceramic or a ceramic matrix composite comprising silicon carbide, where each respective groove of the plurality of grooves exhibits an anchor tooth that spans an edge of the respective groove, and where the plurality of grooves define an average groove width of less than about 20 micrometers.

The plurality of grooves may define an average groove depth of about 10 to about 50 micrometers.

Adjacent grooves of the plurality of grooves may be separated by a distance of about 20 to about 60 micrometers.

The anchor tooth of each respective groove of the plurality of grooves may curve outward from the outer substrate surface to at least partially enclose the respective groove of the plurality of grooves.

The anchor tooth may define at least one of a plunging wave or a spilling wave along the edge of the respective groove.

Forming the plurality of grooves on an outer surface of the substrate may comprise forming the plurality of grooves in at least one of a wavy, a zig-zag, an elliptical, or a circular pattern on the outer surface of the substrate.

The method may further comprise forming a coating on the outer surface of the substrate. The coating may at least partially fill the plurality of grooves formed on the outer substrate surface.

The coating may comprise at least one of an environmental barrier coating, or a thermal barrier coating.

The coating may comprise a bond coat between the substrate and the at least one of the environmental barrier coating, or the thermal barrier coating.

Forming the plurality of grooves may comprise using an ablation laser to remove portions of the substrate. The anchor tooth of each respective groove of the plurality of grooves may be formed as a consequence of the laser ablation.

The ablation laser may comprise a beam frequency of less than about 200 Hz, a beam power of about 15 W to about 25 W, a defocus value of about -60 to about 50, and a cutting speed of about 10 mm/s to about 200 mm/s.

The details of one or more examples are set forth in the accompanying drawings and the description below. Other features, objects, and advantages will be apparent from the description and drawings, and from the claims.

### BRIEF DESCRIPTION OF THE FIGURES

FIG. 1 is a conceptual cross-sectional view of an example article including a substrate that includes a groove and anchor tooth structure and a coating.
FIGS. 2A-2D are conceptual cross-sectional views of plurality of grooves formed on substrate surface.
FIGS. 3A-3D are conceptual top-views of example substrates that include a plurality of grooves arranged in a variety of macroscopic patterns on the outer substrate surface.
FIGS. 4 and 5 are flow diagrams illustrating example techniques for forming a substrate that includes a plurality of grooves each including a respective anchor tooth.
FIG. 6 is a cross-sectional photograph of an example substrate formed with a plurality of grooves and anchor teeth.
FIG. 7 is a topical view of a 2D height map taken of the surface of an example substrate that includes a plurality of grooves and anchor teeth.
FIG. 8 is a perspective view of a 2D height map taken of the surface of an example substrate that includes a plurality of grooves and anchor teeth.
FIG. 9 is a perspective view of a 2D height map taken of the surface of an example substrate that includes a plurality of grooves and anchor teeth.

### DETAILED DESCRIPTION

In general, the disclosure describes techniques for forming a plurality of microscopic grooves on the outer surface of a substrate where each respective groove includes an anchor tooth that curves outward from the outer surface of the substrate along an edge of the groove to at least partially enclose the groove. In some examples the respective anchor teeth may resemble an ocean wave pattern (e.g., a spilling wave or plunging wave). The formed groove and anchor tooth structure may provide an interlocking pattern with the subsequent coating layer to at least partially mechanically adhere the subsequent coating layer to the CMC substrate.

In some examples, the plurality of grooves may be formed using laser ablation in which the respective anchor teeth are formed as a result of ablated substrate material solidifying along the edge of a respective groove. The laser ablation process may reduce the chance of the substrate cracking during processing (e.g., compared to using mechanical machining to form grooves in a surface of a CMC). Laser ablation may also result in a cleaner outer surface compared to other processing techniques (e.g., grit blasting), which may also improve the adhesion between the substrate and a subsequent coating layer. Additionally or alternatively, the laser ablation process may reduce the amount of heat applied to the outer surface of the substrate compared to mechanical machining of the surface, thereby reducing the likelihood of the underlying reinforcement material of the substrate becoming oxidized. For example, due to the microscopic size of the plurality of grooves (e.g., having a groove width of less than 20 micrometers), the amount of heat applied to the substrate during the ablation process is relatively low in comparison to alternative machining techniques (e.g., forming macroscopic topical features).

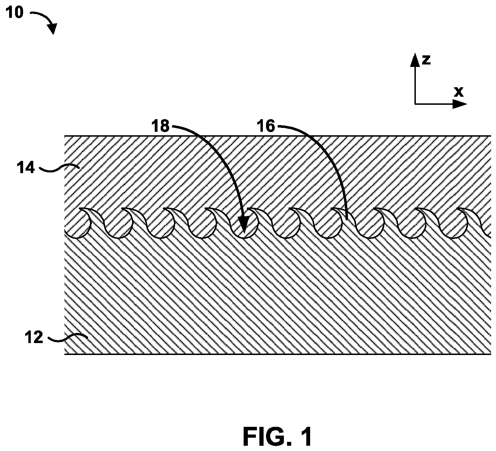

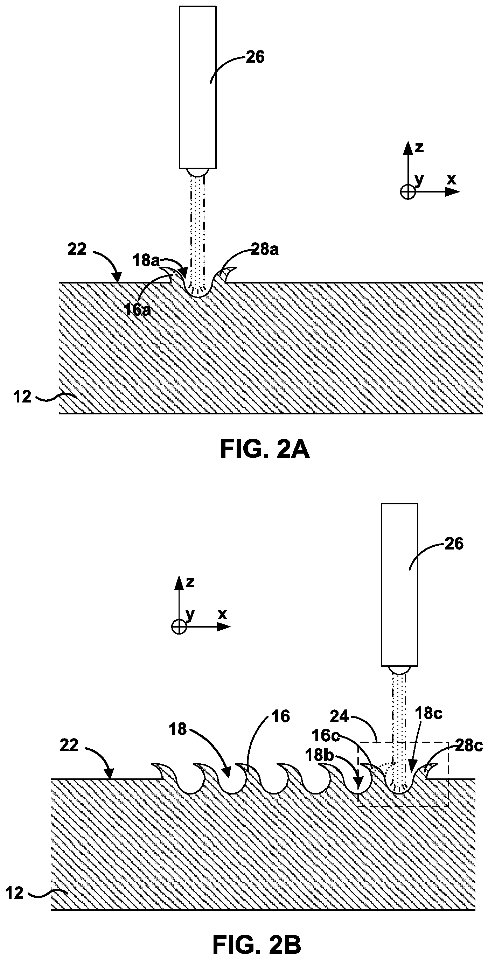

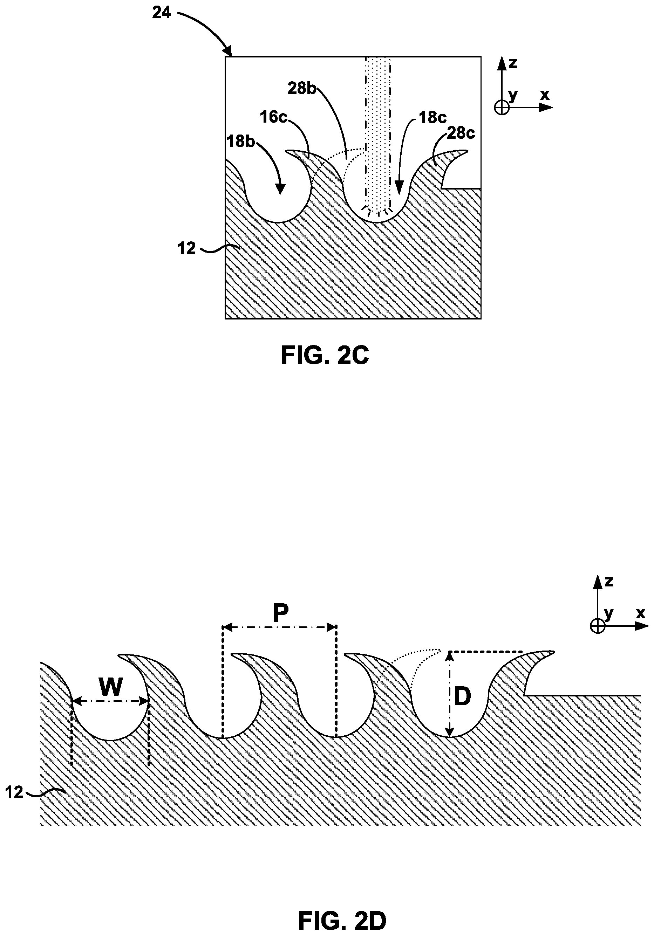

FIGS. 1 and 2 illustrate an example groove and anchor tooth structure in a substrate. FIG. 1 is a conceptual cross-sectional view of an example article 10 including a substrate 12 that includes a groove and anchor tooth structure and a coating 14. Substrate 12 includes a plurality of grooves 18 formed along an outer surface of the substrate 12 (e.g., substrate surface 22 of FIG. 2A). Each respective groove of plurality of grooves 18 includes an anchor tooth 16 that curves outward from substrate surface 22 (e.g., extends outward from surface 22 of substrate 12 in the z-axis/normal direction and bends in the x-axis direction of FIG. 2A) and along the edge of a respective groove (e.g., in the y-axis direction of FIG. 2A) to at least partially enclose the respective groove of the plurality of grooves 18. Each respective anchor tooth 16 is designed to form a partially interlocking geometry with coating 14 in order to mechanically attach coating 14 to substrate surface 22, thereby improving the adherence of coating 14 to substrate 12.

Article 10 may include any applicable structure that may benefit from the improved adhesion established by the groove and anchor tooth structure. In some examples, article 10 may be a component of a high temperature mechanical system. For example, article 10 may be a gas turbine engine component configured to operate in high temperature environments, e.g., operating at temperatures of 1900° to 2100°F. In some examples, article 10 may be a component of a gas turbine engine that is exposed to hot gases, including, for example, a seal segment, a blade track, an airfoil, a blade, a vane, a combustion chamber liner, or the like.

Substrate 12 of article 10 may be formed from various materials including, for example, a superalloy, a fiber reinforced composite, a ceramic matrix composite (CMC), a metal matrix composite, a hybrid material, combinations thereof, or the like. In some examples, substrate 12 may be a CMC substrate. In other examples, substrate 12 may include high temperature alloys based on Ni, Co, Fe, or the like.

In some examples, substrate 12 may include a ceramic or CMC material. In such examples, the ceramic or CMC material may include, for example, a silicon-containing ceramic, such as silica (SiO₂), silicon carbide (SiC), silicon nitride (Si₃N₄), alumina (Al₂O₃), aluminosilicate, or the like. In some examples, the ceramic may be substantially homogeneous and may include substantially a single phase of material. In other examples, substrate 12 may include a matrix material and reinforcement material. Suitable matrix materials may include, for example, carbon, silicon carbide (SiC), silicon carbide aluminum boron silicide, silicon nitride (Si₃N₄), alumina (Al₂O₃), aluminosilicate, silica (SiO₂), or the like. In some examples, the matrix material of the CMC substrate may include carbon, boron carbide, boron nitride, or resin (epoxy/polyimide). The matrix material may be combined with any suitable reinforcement materials including, for example, discontinuous whiskers, platelets, or particulates composed of SiC, Si₃N₄, Al₂O₃, aluminosilicate, SiO₂, or the like. In some examples the reinforcement material may include continuous monofilament or multifilament fibers that include fibers of SiC. The reinforcement fibers may be woven or non-woven. In other examples, substrate 12 may include a metal alloy that includes silicon, such as a molybdenum-silicon alloy (e.g., MoSi₂) or a niobium-silicon alloy (e.g., NbSi₂).

Substrate 12 may be produced using any suitable means. For example, substrate 12 may be produced from a porous preform including reinforcement fibers. The porous preformed may be impregnated with a matrix material using e.g., resin transfer molding (RTM), chemical vapor infiltration (CVI), chemical vapor deposition (CVD), slurry infiltration, melt infiltration, or the like and/or heat treated to produce substrate 12.

Substrate 12 includes a plurality of grooves 18 formed on substrate surface 22. For example, FIGS. 2A-2D show conceptual cross-sectional views of plurality of grooves 18 formed on substrate surface 22. In some examples, the plurality of grooves 18 may be formed using a laser ablation technique. As shown in FIG. 2A, plurality of grooves 18 may be formed by directing an ablation laser 26 at substrate surface 22. Ablation laser 26 may be configured to remove portions of the substrate material from substrate surface 22 via vaporization to create a recess in substrate 12. As ablation laser 26 is drawn over substrate surface 22, the recess is progressively formed along substrate surface 22 (e.g., in the y-axis direction of FIG. 2A, where orthogonal x-y-z axes are shown for purposes of illustration), thereby forming a respective groove 18a of plurality of grooves 18. During the ablation process, portions of the removed substrate material may re-solidify on substrate 12 to form castoffs (e.g. portions 16a and 28a) on both sides of the newly formed groove 18a. The castoffs (portions 16a and 28a) extend outward from substrate surface 22 (e.g., in the z-axis/normal direction) and curve away from the newly formed groove 18a (e.g., curve in the ± x-axis direction). As the laser ablation process continues (e.g., FIGS. 2B and 2C) subsequent grooves 18 are formed on substrate surface 22.

With the formation of each respective groove, e.g., groove 18a, two respective castoffs (e.g. 16a and 28a) are formed, one on each side of the newly formed groove 18a. In some examples, by placing adjacent grooves 18 sufficiently close together (e.g., in a rastering pattern), a castoff of a previously formed groove (e.g. castoff 28a of groove 18a) can be redefined to create an anchor tooth 16 for a respective groove of grooves 18. For example, as shown in FIGS. 2B and 2C (FIG. 2C provides an expanded view of section 24 from FIG. 2B), the formation of groove 18c forms castoffs 16c and 28c on the respective sides of groove 18c. When groove 18c is positioned sufficiently close to previously formed groove 18b, the formation of castoff 16c may be used to redefine previously formed castoff 28b of adjacent groove 18b. The redefinition process establishes the referenced groove-anchor tooth arrangement (e.g., groove 18b and its respective anchor tooth 16c as shown in FIG. 2C).

FIG. 2D shows a conceptual cross-sectional view of substrate 12 illustrating various parameters that may be used to characterize plurality of grooves 18 including, for example, a groove depth (D), a groove width (W), and a period between adjacent grooves (P). In some examples, plurality of grooves 18 may be configured to define a groove depth (D) of about 10 micrometers to about 30 micrometers (e.g., as measured perpendicularly from a lowest point of a groove to a highest point of a peak). In some examples, plurality of grooves 18 may be configured to define a groove width (W) of about 10 micrometers to about 20 micrometers, which, in some examples, may be defined by the width of the beam of ablation laser 26.

In some examples, plurality of grooves 18 may be configured to define a groove period (P) between adjacent grooves 18 of about 25 to about 100 micrometers (e.g., a groove period (P) of about 60 micrometers). In some examples, the selection of the groove period (P) may depend on the groove width (W). For example, narrow grooves (e.g., grooves 18 that define a groove width (W) of about 10 micrometers) may define a shorter groove period (P) to allow for the proper formation of the anchor tooth 16 for each respective groove of grooves 18. Additionally or alternatively, grooves 18 that are characterized by a larger groove width (W) (e.g., about 20 micrometers), may define a longer groove period (P) and still allow for the proper formation of each respective anchor tooth 16. In some examples, the groove depth (D), the groove width (W), and the groove period (P) may be defined as a result of the process parameters used to form plurality of grooves 18. In some examples, the groove depth (D), the groove width (W), and the groove period (P) may be non-uniform or varying in size. In other examples, plurality of grooves 18 may define a substantially uniform and repeating pattern. For example, forming grooves 18 via a laser ablation technique may allow for a high degree of control over the sizing and positioning of plurality of grooves 18, thereby establishing a substantially uniform and repeating pattern.

The laser ablation process may be performed using any suitable ablation laser 26. In some examples, ablation laser 26 may include a plurality or operating parameters including a beam frequency, a beam power, a defocus value, and a travel speed. The operating parameters of ablation laser 26 may be configured to form plurality of grooves 18 that define the selected groove depth (D), groove width (W), and groove period (P). In some examples, the operating parameters of ablation laser 26 may be configured to have a beam frequency of less than about 200 Hz, a beam power of about 15 W to about 25 W, a defocus value of about -60 to about 50, and a cutting speed (e.g., the speed in which ablation laser 26 moves across in the x-y plane of substrate surface 22) of about 10 mm/s to about 200 mm/s.

In some examples, compared to mechanical machining, the laser ablation process may significantly reduce the chance of substrate 12 becoming cracked during the formation of plurality of grooves 18 by reducing the mechanical force applied to substrate surface 22 during processing. Additionally or alternatively, in some examples, due to the relatively small amount of material removed by ablation laser 26, the amount of heat applied and/or generated on substrate surface 22 may remain relatively low during the formation of plurality of grooves 18 compared to other machining techniques. By reducing the heat applied and/or generated on substrate 12 during the laser ablation process, the chance of the material of substrate 12 (e.g. fibers) becoming oxidized prior to the application of coating 14 may be significantly reduced compared to other processing techniques.

In some examples, ablation laser 26 may be configured to form plurality of grooves 18 on substrate surface 22 even when substrate surface 22 is non-planar. For example, in some examples the underlying structure of substrate 12 (e.g., the reinforcement fibers) may cause substrate surface 22 to be uneven or non-planar (e.g., mimicking the pattern of the reinforcement fibers). In such examples, ablation laser 26 may be configured to adjust the incident angle between the ablation beam and substrate surface 22 to produce plurality of grooves 18.

In some examples, a respective anchor tooth 16 on a respective groove 18 may be discontinuous (e.g., anchor tooth 16c may not traverse the entire length of groove 18b). For example, when each groove of plurality of grooves 18 is formed, the anchor tooth produced (e.g., anchor tooth 16c) for a respective groove (e.g., groove 18b) may exhibit a non-uniform and/or a discontinuous pattern along the edge of the respective groove 18b such that the anchor tooth 16c forms a plurality of anchor teeth along the respective groove 18b instead of a single continuous anchor tooth.

In some examples, each respective anchor tooth of anchor teeth 16 may be formed from molten substrate material that is displaced during the formation of grooves 18 and solidifies along the edge of the respective groove of grooves 18. In some examples, each respective anchor tooth of anchor teeth 16 may exhibit a spilling or a plunging wave-like pattern such that each respective anchor tooth of anchor teeth 16 curves outward from substrate surface 22 (e.g., anchor teeth 16c extends out in the z-axis/normal direction and curves in the negative x-axis direction of FIG. 2C) to at least partially enclose the respective groove of the plurality of grooves 18 (e.g., the crest of the anchor tooth 16c partially encloses groove 18b of FIG. 2C), thereby establishing an interlocking geometry with a subsequent coating 14. In some examples, anchor teeth 16 may mechanically link a portion of coating 14 and substrate 12 for additional adhesion strength between coating 14 and substrate 12. In some examples, the interlocking geometry may increase the interface area of the bonding surface between coating 14 and substrate 12 to improve the adhesion between substrate 12 and coating 14. In some examples, the interlocking geometry created via anchor teeth 16 may control or redistribute stresses to reduce residual and/or operating stresses in one or more materials in the component system and may also impart beneficial stresses such as compression in coating 14.

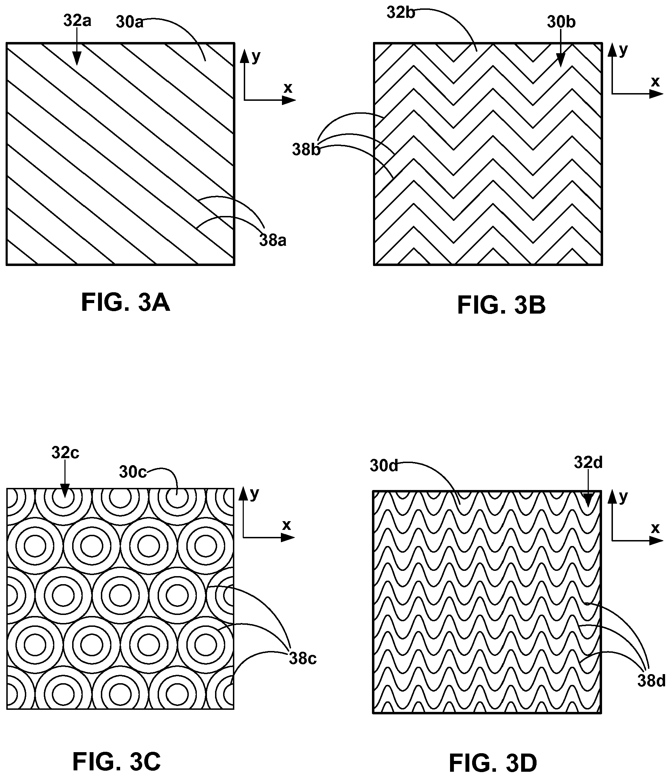

Each groove of the plurality of grooves 18 may be formed on substrate surface 22 such that the grooves 18 progress across the substrate surface (e.g., progress in the x-y plane of FIGS. 2A-2D) to form a macroscopic pattern. The macroscopic pattern defined by the plurality of grooves 18 may be formed in any useful arrangement. For example, FIGS. 3A-3D show conceptual top-views of example substrates 30a, 30b, 30c, 30d that include plurality of grooves 38a, 38b, 38c, 38d arranged in a variety of macroscopic patterns on the substrate surfaces 32a, 32b, 32c, 32d of the respective substrates 30a, 30b, 30c, 30d (e.g., grooves 38a, 38b, 38c, 38d progressing in the x-y plane). As shown in FIGS. 3A-3D, in some examples, the plurality of grooves 38a, 38b, 38c, 38d may define a substantially linear pattern (e.g., groves 38a of FIG. 3A), a zig-zag pattern (e.g., groves 38b of FIG 3B), a curved or curvilinear (e.g., circular) pattern (e.g. groves 38c of FIG. 3C), a wavy pattern (e.g., groves 38d of FIG. 3D), a combination of patterns, or the like. The pattern of the plurality of grooves 38a, 38b, 38c, 38d may extend on substrate surface 32a, 32b, 32c, 32d (e.g., progressing in the x-y plane) to provide mechanical adhesion between substrate 30a, 30b, 30c, 30d and any subsequent coating (e.g., coating 14 of FIG, 1). In some examples, the plurality of grooves 38a, 38b, 38c, 38d may serve to redistribute in-plane stresses (e.g., thermal stress of mechanical stress) exerted on substrate 30a, 30b, 30c, 30d during normal operations. For example, stress exerted on substrate 30a, 30b, 30c, 30d in the y-axis direction of FIG. 3C, may be redistribute across the x-y plane as a result of the macroscopic pattern of plurality of grooves 38a, 38b, 38c, 38d.

Returning to FIG. 1, article 10 may include a coating 14 applied to the outer surface of substrate 12. In some examples, coating 14 may include a bond coat, a thermal barrier coating (TBC), an environmental barrier coating (EBC), an abradable coating layer, a calcia-magnesia-aluminosilicate (CMAS)-resistant layer, combinations thereof, or the like. For example, coating 14 may include an EBC adhered to substrate 12 and an abradable layer on the outer surface of the EBC. In some examples, a single coating layer (e.g., coating 14) may perform two or more of functions (e.g., act as an EBC and abradable layer). Coating 14 may be applied to at least partially fill plurality of grooves 18, thereby forming an interlocking geometry with substrate 12 which improves the adherence of coating 14 to substrate 12 compared to a substrate without the groove and anchor tooth structure. In some examples, coating 14 may be applied by techniques such as spraying (e.g., thermal or plasma spray), pressure vapor deposition (PVD), chemical vapor deposition (CVD), directed vapor deposition (DVD), dipping, electroplating, chemical vapor infiltration (CVI), or the like. In some examples, the composition of coating 14 may be selected based on coefficients of thermal expansion, chemical compatibility, thickness, operating temperatures, oxidation resistance, emissivity, reflectivity, and longevity. Coating 14 may be applied on selected portions and only partially cover substrate 12, or may cover substantially all of substrate 12.

In some examples, coating 14 may include a bond coat that includes any useful material to improve adhesion between substrate 12 and subsequent layers applied to the bond coat. For example, the bond coat may be formulated to exhibit desired chemical or physical attraction between substrate 12 and any subsequent coating applied to the bond coat. In some examples, the bond coat may include silicon metal, alone, or mixed with at least one other constituent including, for example, at least one of a transition metal carbide, a transition metal boride, or a transition metal nitride. Representative transition metals include, for example, Cr, Mo, Nb, W, Ti, Ta, Hf, or Zr. In some examples, the bond coat may additionally or alternatively include mullite (aluminum silicate, Al₆Si₂O₁₃), silica, a silicide, or the like, alone, or in any combination (including in combination with one or more of silicon metal, a transition metal carbide, a transition metal boride, or a transition metal nitride).

Additionally or alternatively, coating 14 may include an EBC, which may provide environmental protection, thermal protection, and/or CMAS-resistance to substrate 12. An EBC may include materials that are resistant to oxidation or water vapor attack, and/or provide at least one of water vapor stability, chemical stability and environmental durability to substrate 12. In some examples, the EBC may be used to protect substrate 12 against oxidation and/or corrosive attacks at high operating temperatures. For example, EBCs may be applied to protect the ceramic composites such as SiC based CMCs. An EBC coating may include at least one of a rare earth oxide, a rare earth silicate, an aluminosilicate, or an alkaline earth aluminosilicate. For example, an EBC coating may include mullite, barium strontium aluminosilicate (BSAS), barium aluminosilicate (BAS), strontium aluminosilicate (SAS), at least one rare earth oxide, at least one rare earth monosilicate (RE₂SiO₅, where RE is a rare earth element), at least one rare earth disilicate (RE₂Si₂O₇, where RE is a rare earth element), or combinations thereof. The rare earth element in the at least one rare earth oxide, the at least one rare earth monosilicate, or the at least one rare earth disilicate may include at least one of Lu (lutetium), Yb (ytterbium), Tm (thulium), Er (erbium), Ho (holmium), Dy (dysprosium), Tb (terbium), Gd (gadolinium), Eu (europium), Sm (samarium), Pm (promethium), Nd (neodymium), Pr (praseodymium), Ce (cerium), La (lanthanum), Y (yttrium), or Sc (scandium). In some examples, the at least one rare earth oxide includes an oxide of at least one of Yb, Y, Gd, or Er.

In some examples, an EBC coating may include at least one rare earth oxide and alumina, at least one rare earth oxide and silica, or at least one rare earth oxide, silica, and alumina. In some examples, an EBC coating may include an additive in addition to the primary constituents of the EBC coating. For example, an EBC coating may include at least one of TiO₂, Ta₂O₅, HfSiO₄, an alkali metal oxide, or an alkali earth metal oxide. The additive may be added to the EBC coating to modify one or more desired properties of the EBC coating. For example, the additive components may increase or decrease the reaction rate of the EBC coating with CMAS, may modify the viscosity of the reaction product from the reaction of CMAS and the EBC coating, may increase adhesion of the EBC coating to substrate 12, may increase or decrease the chemical stability of the EBC coating, or the like.

In some examples, the EBC coating may be substantially free (e.g., free or nearly free) of hafnia and/or zirconia. Zirconia and hafnia may be susceptible to chemical attack by CMAS, so an EBC coating substantially free of hafnia and/or zirconia may be more resistant to CMAS attack than an EBC coating that includes zirconia and/or hafnia.

In some examples, the EBC coating may have a dense microstructure, a columnar microstructure, or a combination of dense and columnar microstructures. A dense microstructure may be more effective in preventing the infiltration of CMAS and other environmental contaminants, while a columnar microstructure may be more strain tolerant during thermal cycling. A combination of dense and columnar microstructures may be more effective in preventing the infiltration of CMAS or other environmental contaminants than a fully columnar microstructure while being more strain tolerant during thermal cycling than a fully dense microstructure. In some examples, an EBC coating with a dense microstructure may have a porosity of less than about 20 vol. %, such as less than about 15 vol. %, less than 10 vol. %, or less than about 5 vol. %, where porosity is measured as a percentage of pore volume divided by total volume of the EBC coating.

In some examples, the EBC may act as a thermal barrier coating (TBC). The TBC may include at least one of a variety of materials having a relatively low thermal conductivity, and may be formed as a porous or a columnar structure in order to further reduce thermal conductivity of the TBC and provide thermal insulation to substrate 12. In some examples, the TBC may include materials such as ceramic, metal, glass, preceramic polymer, or the like. In some examples, the TBC may include silicon carbide, silicon nitride, boron carbide, aluminum oxide, cordierite, molybdenum disilicide, titanium carbide, stabilized zirconia, stabilized hafnia, or the like.

Additionally or alternatively, the coating 14 may include an abradable layer. The abradable layer may include at least one of a rare earth oxide, a rare earth silicate, an aluminosilicate, or an alkaline earth aluminosilicate. For example, an EBC coating may include mullite, barium strontium aluminosilicate (BSAS), barium aluminosilicate (BAS), strontium aluminosilicate (SAS), at least one rare earth oxide, at least one rare earth monosilicate (RE₂SiO₅, where RE is a rare earth element), at least one rare earth disilicate (RE₂Si₂O₇, where RE is a rare earth element), or combinations thereof. The rare earth element in the at least one rare earth oxide, the at least one rare earth monosilicate, or the at least one rare earth disilicate may include at least one of Lu (lutetium), Yb (ytterbium), Tm (thulium), Er (erbium), Ho (holmium), Dy (dysprosium), Tb (terbium), Gd (gadolinium), Eu (europium), Sm (samarium), Pm (promethium), Nd (neodymium), Pr (praseodymium), Ce (cerium), La (lanthanum), Y (yttrium), or Sc (scandium). In some examples, the at least one rare earth oxide includes an oxide of at least one of Yb, Y, Gd, or Er.

The abradable layer may be porous. Porosity of the abradable layer may reduce a thermal conductivity of the abradable layer and/or may affect the abradability of the abradable layer. In some examples, the abradable layer includes porosity between about 10 vol. % and about 50 vol. %. In other examples, the abradable layer includes porosity between about 15 vol. % and about 35 vol. %, or about 20 vol. %. Porosity of the abradable layer is defined herein as a volume of pores or cracks in the abradable layer divided by a total volume of the abradable layer (including both the volume of material in the abradable layer and the volume of pores/cracks in the abradable layer).

The abradable layer may be formed using, for example, a thermal spraying technique, such as, for example, plasma spraying. Porosity of the abradable layer may be controlled by the use of coating material additives and/or processing techniques to create the desired porosity. In some examples, substantially closed pores may be desired.

For example, a coating material additive that melts or burns at the use temperatures of the component (e.g., a blade track) may be incorporated into the coating material that forms the abradable layer. The coating material additive may include, for example, graphite, hexagonal boron nitride, or a polymer such as a polyester, and may be incorporated into the coating material prior to deposition of the coating material over outer surface layer 17 to form the abradable layer. The coating material additive then may be melted or burned off in a subsequent heat treatment, or during operation of the gas turbine engine, to form pores in the abradable layer. The post-deposition heat-treatment may be performed at up to about 1500°C.

The porosity of the abradable layer can also be created and/or controlled by plasma spraying the coating material using a co-spray process technique in which the coating material and coating material additive are fed into the plasma stream with two radial powder feed injection ports. The feed pressures and flow rates of the coating material and coating material additive may be adjusted to inject the material on the outer edge of the plasma plume using direct 90 degree angle injection. This may permit the coating material particles to soften but not completely melt and the coating material additive to not burn off but rather soften sufficiently for adherence in the abradable layer.

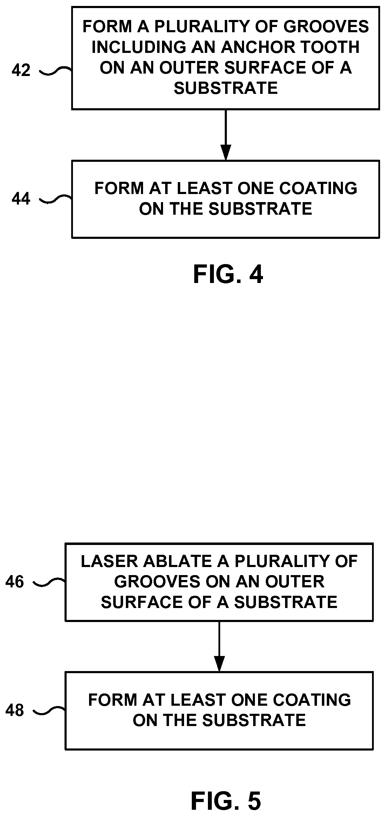

The groove and anchor tooth structure of substrate 12 may be formed using any suitable technique. For example, FIGS. 4 and 5 are flow diagrams illustrating example techniques for forming a substrate that includes a plurality of grooves 18 each including a respective anchor tooth 16, formed on the outer surface 22 of the substrate 12. While the techniques of FIGS. 4 and 5 are described with concurrent reference to the conceptual diagram of FIGS. 1-3, in other examples, the techniques of FIGS. 4 and 5 may be used to form other articles, or article 10 may be formed using a technique different than that described in FIGS. 4 and 5.

The technique of FIG. 4 includes forming a plurality of grooves 18 on substrate surface 22, where each respective groove of the plurality of grooves 18 includes an anchor tooth 16 (40). As described above, plurality of grooves 18 and each respective anchor tooth 16 may be formed using any suitable technique including, for example, laser ablation, plasma cutting, or the like. In some examples, each respective anchor tooth 16 may curve outward from substrate surface 22 (e.g., extending out in the z-axis/normal direction of surface 22 and curving in the negative x-axis/parallel direction as shown in FIG. 1) to at least partially enclose the receptive groove of the plurality of grooves 18 (e.g., the crest of the anchor tooth 16c partially encloses the groove 18b). In some examples each respective anchor tooth 16 may exhibit a spilling or a plunging wave-like pattern such that the crest of each respective anchor tooth 16 partially encloses the respective groove. As describe above, plurality of grooves 18 may be formed (40) by laser ablation. In such examples, an ablation laser 26 may be directed at substrate surface 22 to remove portions of the substrate material. During the ablation process, portions of the removed substrate material may re-solidify on substrate 12 to form castoffs (e.g. portions 16a and 28a) on both sides of the newly formed groove (e.g., groove 18a). The laser ablation process may redefine a prior castoff (e.g., redefine castoff portion 28b) to form the anchor tooth for an adjacent groove (e.g., anchor tooth 16c for groove 18b). In some examples, the plurality of grooves 38a, 38b, 38c, 38d may be formed to define a macrostructure pattern (e.g., linear, zig-zag, circular, wavy, or the like) progressing on substrate surface 32a, 32b, 32c, 32d.

The technique of FIG. 4 also includes forming at least one coating 14 on substrate 12 (42). Plurality of grooves 18 and each respective anchor tooth 16 may define an interlocking geometry between coating 14 and substrate 12 that allow coating 14 to mechanically link with a portion of substrate 12 for additional adhesion strength between coating 14 and substrate 12. In some examples, the increase the interface area of the bonding surface established by the groove and anchor tooth structure may improve the adhesion between coating 14 and substrate 12.

FIG. 5 is another flow diagram illustrating example techniques for forming article 10 that includes forming a plurality of grooves 18 on substrate surface 22 via laser ablation, where each respective groove of the plurality of grooves 18 includes an anchor tooth 16 (46). As described above, each respective anchor tooth 16 may be formed as a consequence of the laser ablation process. For example, as portions of substrate are removed via the laser ablation process to define plurality of grooves 18, portions of the ablated substrate material may re-solidify as castoffs along the edge of the recently formed groove (e.g., castoff protions 16c and 28c of formed groove 18c). The resolidified castoff may form the respective anchor tooth 16 for an adjacent groove (e.g., castoff portion 16c forms the anchor tooth for groove 18b). In some examples, each respective anchor tooth 16 may curve outward from substrate surface 22 (e.g., extending out in the z-axis/normal direction and curving in the negative x-axis direction of FIG. 1) to at least partially enclose the receptive groove of the plurality of grooves 18 (e.g., the crest of the anchor tooth 16c partially encloses the groove 18b). In some examples each respective anchor tooth 16 may exhibit a spilling or a plunging wave-like pattern such that the crest of anchor tooth 16 partially encloses the respective groove. As describe above, plurality of grooves may be formed (46) to define a macrostructure pattern progressing on the substrate surface (e.g., grooves 38a, 38b, 38c, 38d forming linear, zig-zag, circular, wavy, or the like macrostructure patterns).

The technique of FIG. 5 also includes forming at least one coating 14 on substrate 12 (48). Plurality of grooves 18 and each respective anchor tooth 16 may define an interlocking geometry between coating 14 and substrate 12 that allow coating 14 to mechanically link with a portion of substrate 12 for additional adhesion strength between coating 14 and substrate 12. In some examples, the increase the interface area of the bonding surface established by the groove and anchor tooth structure may improve the adhesion between coating 14 and substrate 12.

### EXAMPLES

### Example 1

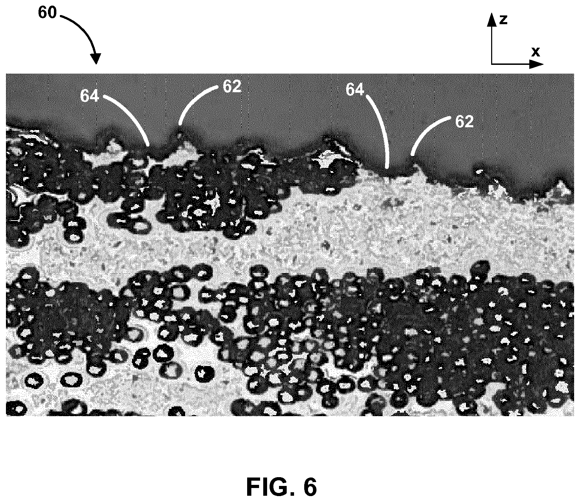

FIG. 6 is a cross-sectional photograph of an example substrate 60 formed with a plurality of grooves 64 and anchor teeth 62. Substrate 60 included a silicon carbide-based ceramic matrix composite with a Si+SiC matrix. Each respective groove of plurality of groove 64 were formed on substrate 60 using an ablation laser configured at an average power of approximately 20W, a scan speed of approximately 175 mm/s and a pulse frequency of approximately 100 kHz. Plurality of grooves 64 defined an average groove depth (D) of approximately 10 µm, a groove width (W) of approximately 30 µm, and a period between adjacent grooves (P) of approximately 50 µm. As shown in the photo of FIG. 6 each respective groove of plurality of grooves 64 included an anchor tooth 62 that partially enclose a respective groove.

### Example 2

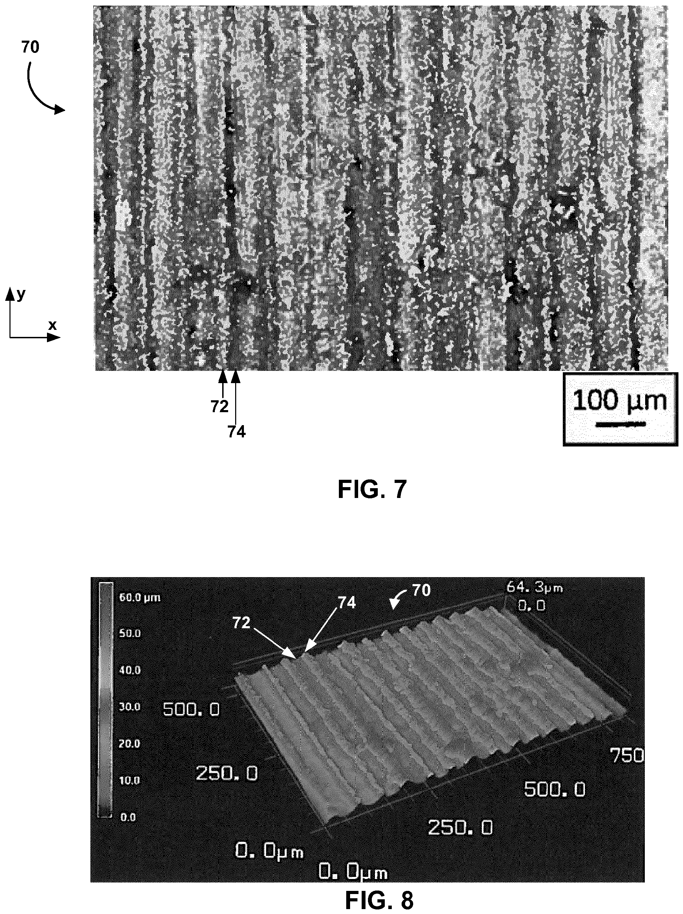

FIGS. 7 and 8 show a topical (FIG. 7) and perspective views (FIG. 8) of a 2D height map taken of the surface of an example substrate 70 that includes a plurality of grooves 72 and anchor teeth 74 produced via laser ablation. Substrate 70 included a silicon carbide-based ceramic matrix composite with a Si+SiC matrix. Each respective groove of plurality of groove 72 were formed on substrate 70 using an ablation laser configured at an average power of approximately 20W, a scan speed of approximately 175 mm/s and a pulse frequency of approximately 100 kHz. Plurality of grooves 72 defined an average groove depth (D) of approximately 20 µm, a groove width (W) of approximately 30 µm, and a period between adjacent grooves (P) of approximately 60 µm. As shown in the 2D height maps of FIGS. 7 and 8, each respective groove of plurality of grooves 72 included an anchor tooth 74 that partially enclose a respective groove. Plurality of grooves 72 were formed to define a linear macrostructure pattern (e.g., linear in the y-axis direction of FIG. 7).

Substrate 70 was subsequently coated with a two layer system of silicon and ytterbium disilicate. Substrate 70 demonstrated improved adhesion at the substrate/coating interface evidenced by coating splat formations being tightly bonded to the substrate anchor tooth pattern with no sign of coating separation.

### Example 3

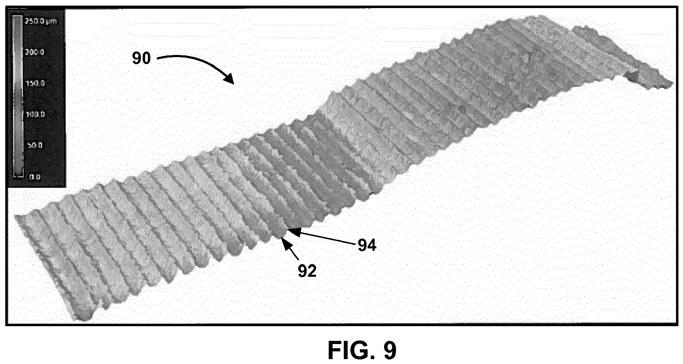

FIG. 9 shows another perspective view of a 2D height map taken of the surface of an example substrate 90 that includes a plurality of grooves 92 and anchor teeth 94 produced via laser ablation. Substrate 90 included a silicon carbide-based ceramic matrix composite with a Si+SiC matrix. Each respective groove of plurality of groove 92 were formed on substrate 90 using an ablation laser configured at an average power of approximately 20W, a scan speed of approximately 175 mm/s and a pulse frequency of approximately 100 kHz. Plurality of grooves 92 defined an average groove depth (D) of approximately 20 µm, a groove width (W) of approximately 30 µm, and a period between adjacent grooves (P) of approximately 60 µm. As shown in the 2D height map of FIG. 9, each respective groove of plurality of grooves 92 included an anchor tooth 94 that partially enclose a respective groove. Plurality of grooves 92 were formed to define a linear macrostructure pattern on an uneven surface of underlying substrate 90.

Substrate 90 was subsequently coated with a two layer system of silicon and ytterbium disilicate. Substrate 90 demonstrated improved adhesion at full coating thickness with no separation. The normal residual coating stress was negated by the surface topography which allows mechanical cementation of the coating particles.

Various examples have been described. These and other examples are within the scope of the following claims.

## Claims

1. An article comprising:
a substrate comprising a ceramic or a ceramic matrix composite comprising silicon carbide, wherein the substrate defines an outer substrate surface and a plurality of grooves formed in the outer substrate surface, wherein each respective groove of the plurality of grooves exhibits an anchor tooth that spans an edge of the respective groove, and wherein the plurality of grooves define an average groove width less than about 20 micrometers; and
a coating formed on the outer surface of the substrate, wherein the coating at least partially fills the plurality of grooves of the substrate.

2. The article of claim 1, wherein the plurality of grooves define an average groove depth of about 10 to about 50 micrometers.

3. The article of claims 1 or 2, wherein adjacent grooves of the plurality of grooves are separated by a distance of about 20 to about 60 micrometers.

4. The article of any one of claims 1 to 3, wherein the anchor tooth of each respective groove of the plurality of grooves at least partially secures the coating to the substrate.

5. The article of any one of claims 1 to 4, wherein each groove of the plurality of grooves define at least one of a wavy, a zig-zag, an elliptical, or a circular pattern progressing laterally on the outer substrate surface.

6. The article of any one of claims 1 to 5, wherein the anchor tooth of each respective groove of the plurality of grooves curves outward from the outer substrate surface to at least partially enclose the respective groove of the plurality of grooves.

7. The article of claim 6, wherein the anchor tooth defines at least one of a plunging wave or a spilling wave along the edge of the respective groove.

8. The article of any one of claims 1 to 7, wherein the coating comprises at least one of an environmental barrier coating or a thermal barrier coating.

9. The article of claim 8, wherein the coating comprises a bond coat positioned between the substrate and the at least one of the environmental barrier coating or the thermal barrier coating.

10. A method for forming an article, the method comprising:
forming a plurality of grooves on an outer substrate surface of a substrate, wherein the substrate comprises a ceramic or a ceramic matrix composite comprising silicon carbide, wherein each respective groove of the plurality of grooves exhibits an anchor tooth that spans an edge of the respective groove, and wherein the plurality of grooves define an average groove width of less than about 20 micrometers.

11. The method of claim 10, wherein the plurality of grooves define an average groove depth of about 10 to about 50 micrometers, and wherein adjacent grooves of the plurality of grooves are separated by a distance of about 20 to about 60 micrometers.

12. The method of claim 10 or 11, wherein the anchor tooth of each respective groove of the plurality of grooves curves outward from the outer substrate surface to at least partially enclose the respective groove of the plurality of grooves.

13. The method of any one of claims 10 to 12, wherein forming the plurality of grooves on an outer surface of the substrate comprises forming the plurality of grooves in at least one of a wavy, a zig-zag, an elliptical, or a circular pattern on the outer surface of the substrate.

14. The method of any one of claims 10 to 13, further comprising forming a coating on the outer surface of the substrate, wherein the coating at least partially fills the plurality of grooves formed on the outer substrate surface.

15. The method of any one of claims 10 to 14, wherein forming the plurality of grooves comprises using an ablation laser to remove portions of the substrate, wherein the anchor tooth of each respective groove of the plurality of grooves is formed as a consequence of the laser ablation.
